# EUROPEAN PATENT APPLICATION

(11) **EP 1 583 166 A2**
(43) Date of publication of application: **05.10.2005**
(21) Application number: 05006873.3
(22) Date of filing: 30.03.2005
(51) Int. Cl.: H01L 51/30

(54) **Organic electroluminescence device comprising Ir complexes immobilized on ZrO2**

(30) Priority: 01.04.2004 JP 2004109358
(71) Applicant: SEIKO EPSON CORPORATION, Tokyo 163-0811 (JP)
(72) Inventor: Morii, Katsuyuki, Suwa-shi, Nagano-ken, 392-8502 (JP)
(74) Representative: HOFFMANN EITLE

(57) **Abstract**

The present invention provides an organic electroluminescence device which is highly efficient and has a long operation life. A metallic compound is used as an electron transport layer and a metal complex which is capable of triplet emission is used as a light-emitting element. An organic material which is mainly responsible for electron hole transport is provided so as to surround the electron transport layer and the light-emitting element. The invention is also related to a method of manufacturing this device and to an electronic equipment containing the same.

## Description

### [Field of the Invention]

The present invention relates to an organic electroluminescence device manufactured by using a liquid-phase process, a manufacturing method thereof and electronic equipment.

### [Description of the Related Art]

An organic electroluminescence (EL) element, which is a constituent member of the organic electroluminescence device, generally has an organic light-emitting layer made of an organic light-emitting material between an anode and a cathode. Electrons and electron holes which are injected through the anode and the cathode are recombined in the light-emitting layer and an excited energy is emitted as light. Such organic EL device usually has an electron hole injection layer (also called as "electron hole transport layer") that becomes an anode buffer and an electron injection layer (also called as "electron transport layer") that becomes a cathode buffer because a charge injection barrier among the electrodes and the light-emitting layer is high. They are provided in layers in the organic EL device.

An electron injection material (also called as "electron transport material") has a high reactivity with oxygen and the like in principal, in other words, it has a high probability of undergoing chemical change under normal conditions. Therefore, it is difficult to maintain a reliability of the electron injection material for a prolonged period. For this reason, a part including the cathode which injects and transfers electrons becomes one of deterioration factors. Meanwhile, demands for the organic electroluminescence have been increasing every day and especially the reliability is becoming a major issue. A conventional electron injection transfer layer made of previously-existing organic materials is not sufficient and a radical improvement is needed.
[Patent Document 1]
   Japanese Unexamined Patent Publication No. 0-12377
[Patent Document 2]
   Japanese Unexamined Patent Publication No. 2000-252076
[Patent Document 3]
   Japanese Unexamined Patent Publication No. 2000-252079
[Non-Patent Document 1]
   Applied Physics Letter 51, (1997), p.34
[Non-Patent Document 2]
   Applied Physics Letter 71, (1997), p.34
[Non-Patent Document 3]
   Nature 357, 477 (1992)

### [Disclosure of the Invention]

### [Problems to Be Solved]

The present invention has been developed in consideration of the above-mentioned problems, and intended to provide an organic electroluminescence device which is reliable and/or has a long operation life.

The present invention also intends to provide electronic equipment having an organic electroluminescence device according the present invention.

### [Means to Solve the Problems]

An organic electroluminescence device of the present invention has a light-emitting functional organic material part provided between an electrode formed on a base body and an electrode that opposes the electrode. The functional organic material layer contains at least a particle of a metallic compound, a metal complex and an organic material.

The organic electroluminescence device according to the present invention conducts an electron injection and propagation, which is a key factor for deterioration, through not only the organic material but also together with an inorganic material.

In the organic electroluminescence device according to the present invention, in addition to the light-emitting functional part, a hole injection layer, a hole transport layer and an electron injection layer may exist in a form of at least a layer or layers.

In a manufacturing method according to the present invention, a liquid-phase process is used. When the liquid-phase process is used, the light-emitting functional part can be more easily formed compared with a case where it is formed by a vapor process. Such liquid-phase process includes a spin-coat method, a dip method and a droplet discharging method.

The electronic equipment according to the present invention includes the above-described organic electroluminescence device of the present invention.

### [Description of the Preferred Embodiments]

The embodiments of the present invention will now be described in detail with reference to the accompanying drawings.

### [Brief Description of the Drawings]

[FIG. 1] FIG. 1 is a plan view schematically showing a structure of an organic electroluminescence device according to the present invention.
[FIG. 2] FIG. 2 is an enlarged sectional view along the line A-A shown in FIG. 1.
[FIGs. 3a through 3c] FIGs. 3a through 3c are sectional views for explaining manufacturing processes of the organic electroluminescence device in sequence.
[FIGs. 4a and 4b] FIGs. 4a and 4b are sectional views for explaining the following manufacturing process after the process shown in FIG. 3c.
[FIG. 5] FIG. 5 is a frame format of an embodiment of the present invention.
[FIG. 6] FIG. 6 is a perspective view of an electronic equipment of the present invention.

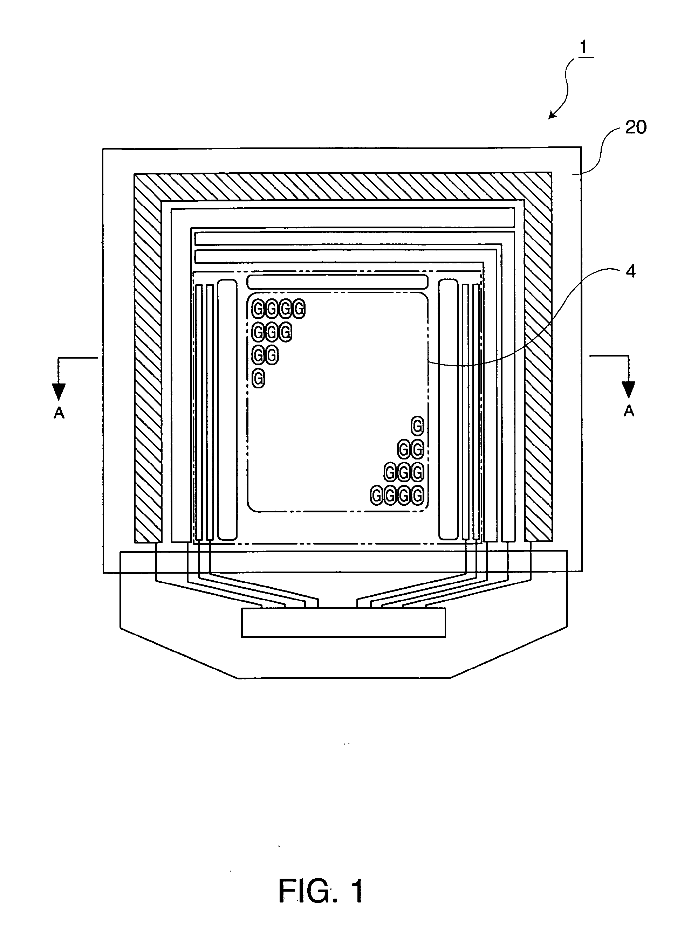

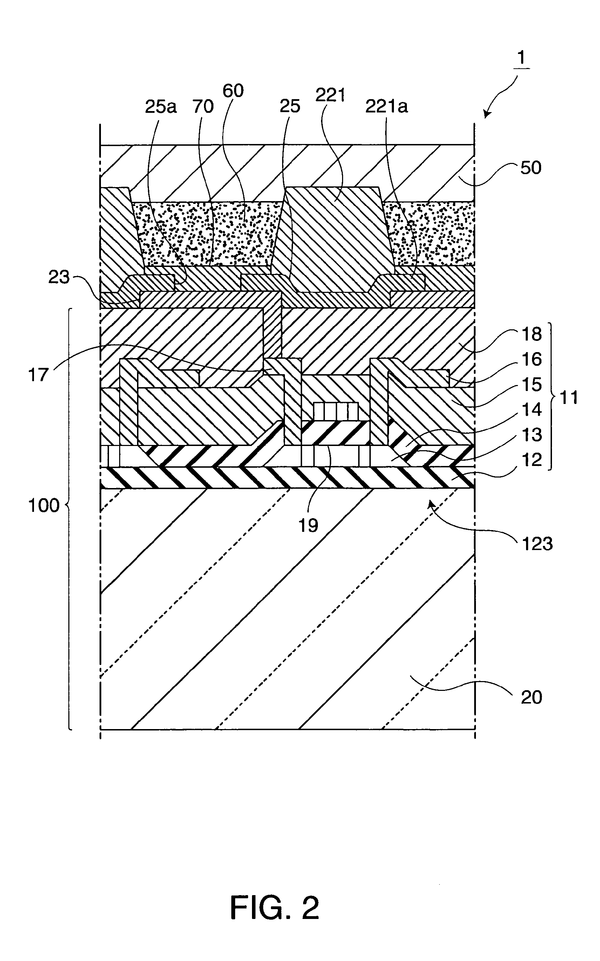

An example of an organic electroluminescence device according to the present embodiment is described with reference to FIG. 1 and FIG. 2. FIG. 1 is a plan view schematically showing an organic electroluminescence device 1. FIG. 2 is a sectional view of the organic electroluminescence device along the line A-A shown in FIG. 1 schematically showing a sectional structure.

The organic electroluminescence device 1 has a dot that emits a green (G) light in a real display region 4 as shown in FIG. 1 and this enables the organic electroluminescence device to display in one color.

As shown in FIG. 2, the organic electroluminescence device 1 of this embodiment is a bottom-emission type. This means that the light is taken out from a substrate 20 side. Therefore, a transparent or translucent substrate made of such as glass, quartz and resin (plastic or a plastic film) is used as the substrate 20.

When the organic electroluminescence device is a so-called top-emission type, the light is taken out from a sealing substrate (not shown in the figures) side which is opposed to the substrate 20. Therefore, either the transparent substrate or an opaque substrate can be used as the substrate 20. As the opaque substrate, for example, ceramics such as alumina, a metal sheet treated with insulating such as a stainless steel treated with surface oxidation, heat-hardening resin and thermoplastic resin can be used.

In this embodiment, an electroluminescence element is provided on a base body 100. The base body 100 includes the substrate 20 and a circuit member 11 formed on the substrate 20.

The circuit member 11 includes a protection layer 12 formed on the substrate 20 and made of, for example, an oxide silicon layer, a driving thin film transistor (TFT) 123 formed on the protection layer, a first interlayer insulation layer 15 and a second interlayer insulation layer 18. The driving TFT 123 includes a semiconductor layer 13 made of silicon, a gate insulating layer 14 formed on the semiconductor layer 13, a gate electrode 19 formed on the gate insulating layer 14, a source electrode 16 and a drain electrode 17.

The organic electroluminescence element is provided on the circuit member 11. The organic electroluminescence element includes a picture electrode 23 which serves as an anode, a hole injection layer 70 which injects or transports electron holes from the picture electrode 23 and is formed on the picture electrode 23, an organic light-emitting layer 60 having a light-emitting function and formed on the hole injection layer 70, and a cathode 50 formed on the organic light-emitting layer 60. Although not shown in the figure, an electron-injection layer that injects or transports electrons from the cathode 50 may be provided between the organic light-emitting layer 60 and the cathode 50 according to need.

When an electron hole injected from the hole injection layer 70 and an electron from the cathode 50 are bound each other in the organic light-emitting layer 60, the above-described organic electroluminescence element 1 emits light.

The picture electrode 23 which serves as the anode is made of a transparent conductive material because the bottom-emission type is adopted in this embodiment. As the transparent conductive material, besides Indium Tin Oxide (ITO), for example, Indium Zinc Oxide (IZO) (registered trademark) (Idemitsu Kosan Co., Ltd. make) and the like can also be used.

A thickness of the picture electrode 23 is not particularly limited. For example, it may be 50-200 nm. A surface of the picture electrode 23 is made to be lyophilic by being treated in an oxygen plasma. At the same time, the surface of the electrode is cleaned and a work function is adjusted. The oxygen plasma treatment may be performed in, for example, the following conditions: 100-800 kW of plasma power, 50-100 ml/min of oxygen gas flow rate, 0.5-10 mm/sec of substrate carrying speed and 70-90 °C of substrate temperature.

As an electron hole transport material of the hole injection layer 70, for example, 4-polyethelenedioxithiophene (PEDOT) and polystyrenesulphonic acid (PSS) (see Formula 1) manufactured by Bayer AG can be used. For example, a material in which a mixture of polythiophene derivative such as PEDOT and PSS and the like dissolved in solvent can be used. As a polar solvent, for example, isopropyl alcohol (IPA), n-butanol, γ -butyrolactone, N-methylpyrrolidone (NMP), 1,3-dimethyl-2-imidazolidinone (DMI) and its derivatives and glycol ether series such as carbitol acetate and butyl carbitol acetate can be named. The embodiment is not limited to this, for example, this layer may be omitted.

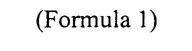

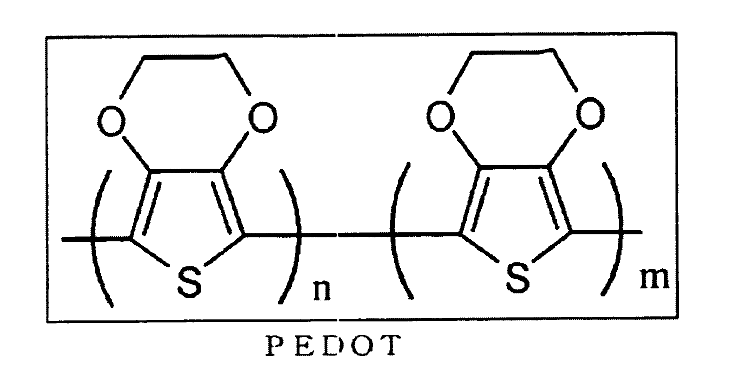

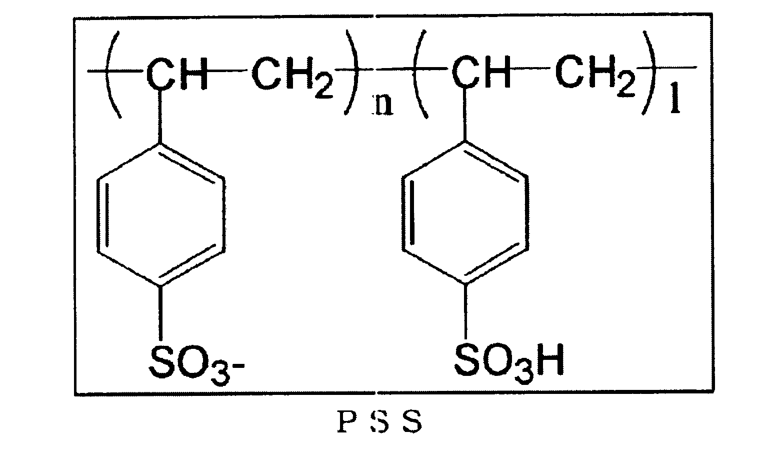

As a light-emitting material for a light emitting functional part 60, such organic material as polyvinyl carbazole (see Formula 2) and triallylamine-base polymer (for example, ADS254BE, see Formula 3), such metal complex as iridium metal complex having 2,2'- bipyridine-4,4'-dicarboxylic acid (see Formula 4) as its ligand and such metallic compound particles as zirconium oxide, titanium oxide and silicon carbide can be used.

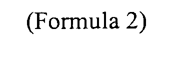

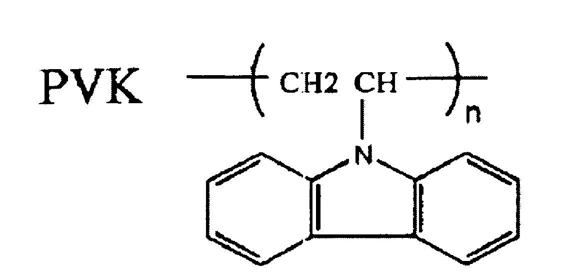

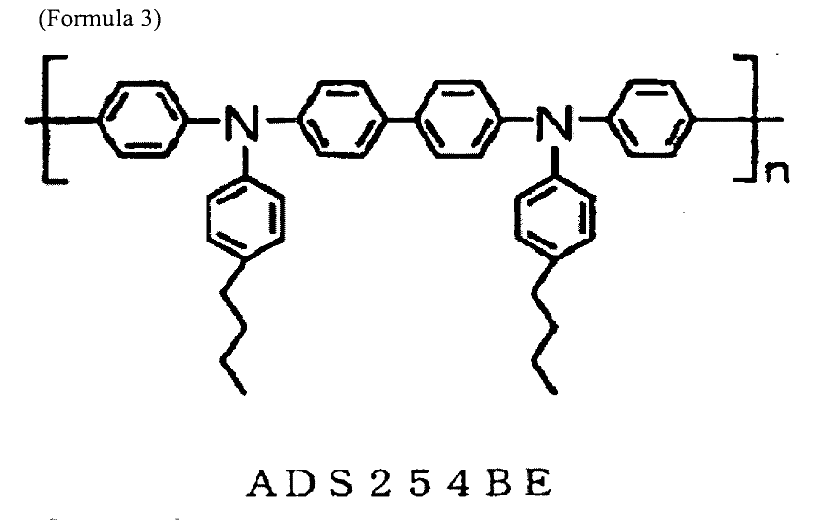

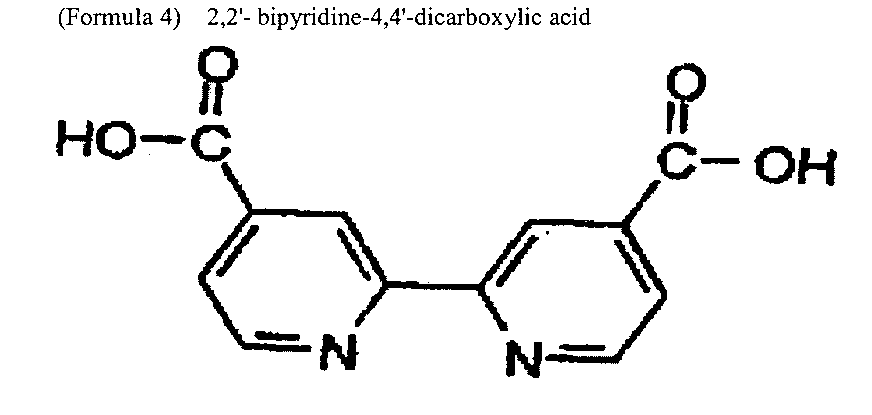

The cathode 50 is formed so as to cover the light emitting functional part 60 and an organic bank layer 221.

As a material for forming the cathode 50, it is preferable to use a material with a small work function in a light emitting functional part 60 side (the bottom side) of the cathode 50. For example, calcium, magnesium and the like can be used. In the upper side (the sealing side) of the cathode 50, a material with higher work function than that of the light emitting functional part 60 side, which is, for example, aluminum can be used. When aluminum is used in the cathode 50, this aluminum can serve as a reflecting layer that reflects a light emitted from the light emitting functional part 60. A thickness of the cathode 50 is not particularly limited. For example, it may be 100-1000 nm, more preferably, 200-500 nm. In this embodiment, the cathode 50 does not have to be transparent because the organic electroluminescence device of this embodiment is the bottom-emission type.

The surface of the second interlayer insulation layer 18 on which the picture electrode 23 is formed is covered with the picture electrode 23, a lyophilic control layer 25 and the organic bank layer 221. The lyophilic control layer 25 is mainly made of the lyophilic material such as silicon oxide and the organic bank layer 221 is made of acrylic resin, polyimide and the like. The picture electrode 23 has an opening 25a formed in the lyophilic control layer 25 and an opening 221 a formed in the organic bank layer 221. The hole injection layer 70 and the light emitting functional part 60 are piled up in this order from the picture electrode 23 side in the opening 25a and the opening 221 a. In this embodiment, the lyophilic material of the lyophilic control layer 25 is at least more lyophilic than the acrylic resin or the polyimide of the organic bank layer 221.

### (Embodiment of manufacturing method)

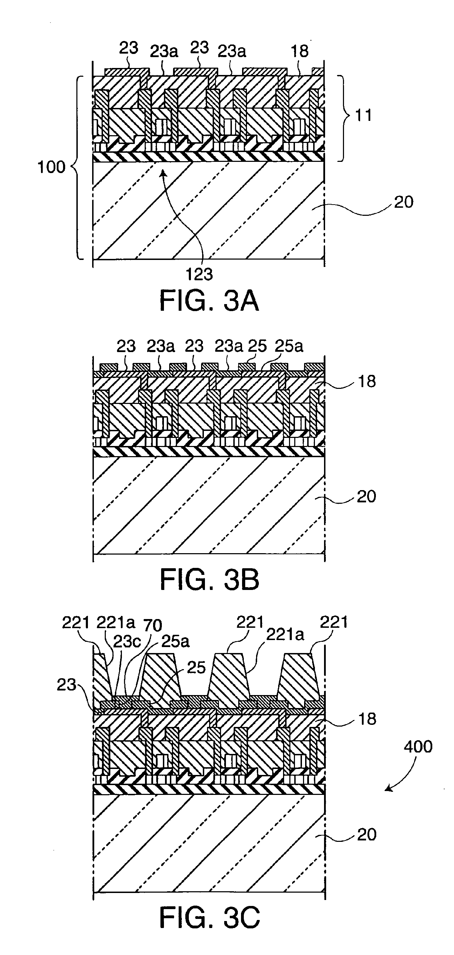

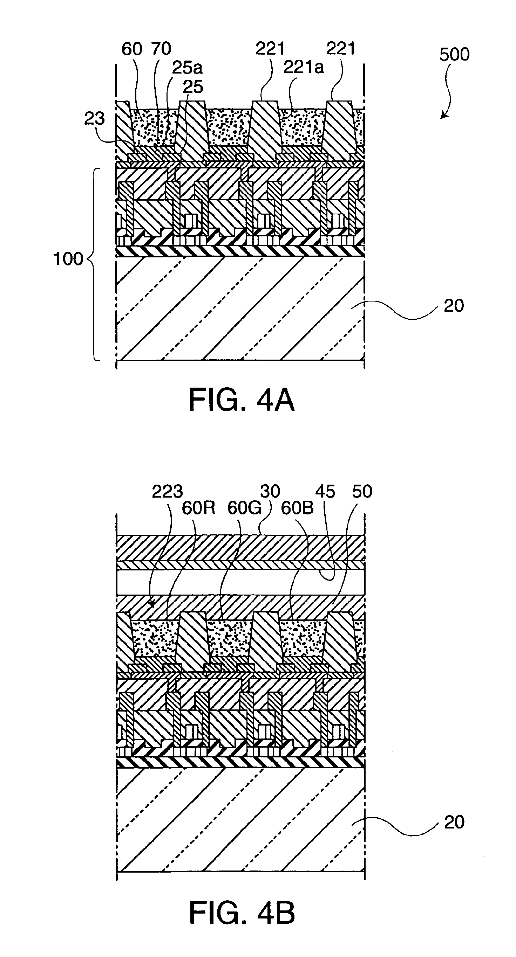

Next, one example of a method of manufacturing the organic electroluminescence device 1 according to the present embodiment will be described with reference to FIGs. 3a through 3c and FIGs. 4a and 4b. Each sectional view shown in FIG. 3 and FIG. 4 corresponds to a sectional view along the line A-A in FIG. 1.

(1) Firstly, components as far as the circuit member 11 shown in FIG. 2 are formed on the substrate 20 by a commonly used method and the base body 100 is obtained as shown in FIG. 3a. Subsequently, a transparent conductive layer which becomes the picture electrode 23 is formed so as to cover the whole area of the top layer (the second interlayer insulation layer 18) of the base body 100. Then, this transparent conductive layer is patterned so as to form the picture electrode 23 has an opening 23a.

(2) Next, the lyophilic control layer 25 made of the insulating layer is formed on the picture electrode 23 and the second interlayer insulation layer 18 as shown in FIG. 3b. Subsequently, a black matrix layer (not shown in the figures) is formed in a concave portion formed between two different picture electrodes 23 in the lyophilic control layer 25. To be more specific, the black matrix layer is formed by sputtering, for example, chromium metal in the concave portion of the lyophilic control layer 25.

(3) Next, the organic bank layer 221 is formed on a predetermined position of the lyophilic control layer 25, more particularly, so as to cover the black matrix layer as shown in FIG. 3c. The organic bank layer is formed by forming an organic layer. The organic layer may be formed by, for example, applying a solution in which resist such as acrylic resin and polyimide resin is dissolved. The solution can be applied by a spin-coat method, a dip-coat method and the like. Any material can be adopted to form the organic layer as long as it will not dissolve in a solvent of the later-described liquid material and it is easily patterned by etching and the like. Then, the organic layer is patterned by a photolithography technique or an etching technique and the opening 221a is formed in the organic layer. In this way, the organic bank layer 221 is formed.

Next, a lyophilic area and a lyophobic area are formed by a plasma treatment. To be more specific, the plasma treatment includes a preheating process, a lyophilic process, a lyophobic process and a cooling process. In the lyophilic process, an upper face of the organic bank layer 221, a wall surface of the opening 221a, an electrode face 23c of the picture electrode 23 and an upper face of the lyophilic control layer 25 are made to be lyophilic. In the lyophobic process, the upper face of the organic bank layer 221 and the wall surface of the opening 221 a are made to be lyophobic.

To be more specific, a treated body (a layered body composed of the picture electrode 23 and the organic bank layer 221 and the like provided on the base body 100) is heated to a predetermined temperature, for example, about 70-80 °C. Subsequently, the treated body is treated in atmosphere with the plasma treatment (the oxygen plasma treatment) by using oxygen as a reactive gas. This is the lyophilic process. Then, as the lyophobic process, another plasma treatment (CF₄ plasma treatment) using tetrafluoromethane as the reactive gas is performed. Then, the treated body that was heated in the plasma treatment is cooled down to the room temperature. In this way, the lyophilic area and the lyophobic area are respectively formed in predetermined positions.

In the CF₄ plasma treatment, the electrode face 23c of the picture electrode 23 and the lyophilic control layer 25 will be also affected to some extent. However, ITO that is used to form the picture electrode 23, silicon oxide, titanium oxide and the like used to form the lyophilic control layer 25 have a weak affinity for fluorine. Therefore, hydroxyl given in the lyophilic process will not be replaced by fluorine group and the lyophilic area is maintained.

(4) Next, the hole injection layer 70 is formed as shown in FIG. 3c. To form the hole injection layer 70, a thin film having a thickness of from a few nanometers to a few hundreds nanometers is formed by a liquid-phase process. The liquid-phase process is a method of forming a thin film by dissolving or dispersing a desired film material in a liquid and applying the liquid with the spin-coat method, the dip-method or a droplet discharging method (an ink-jet method) and the like. The spin-coat method and the dip-method are ideal for applying the whole surface. Meanwhile, the thin film can be patterned in a desired position with the droplet discharging method. Such liquid-phase process is also adopted in the later-descirbed film forming processes to form the light emitting functional part, the electron injection layer, the cathode and the like.

In the hole injection layer forming process, the hole injection layer 70 can be formed in a predetermined position without patterning by etching and the like because an electron hole transport layer forming material is applied on the electrode face 23c by the droplet discharging method.

In case where the hole injection layer forming material is selectively applied by the droplet discharging method (the ink-jet method), firstly, the hole injection layer forming material is filled in a droplet discharge head (not shown in the figures). Secondly, a discharge nozzle of the droplet discharge head is opposed to the electrode face 23c placed in the opening 25a that is formed in the lyophilic control layer 25. Thirdly, a droplet whose volume is controlled is discharged to the electrode face 23c from the discharge nozzle while the droplet discharge head and the substrate are relatively moved.

The droplet discharged from the discharge nozzle spreads on the electrode face 23c which is treated with the lyophilic treatment and the droplet is then filled in the opening 25a of the lyophilic control layer 25. While, the droplet is shed and will not be adhered to the upper face of the organic bank layer 221 which is treated with the lyophobic (ink) treatment. Therefore, even if the droplet is discharged afied from the predetermined position and to the upper surface of the organic bank layer 221, the upper surface will not be wet with the droplet and the shed droplet will fall into the opening 25a of the lyophilic control layer 25. In this way, the droplet is easily and precisely provided on the predetermined position.

To form the hole injection layer 70, as described above, for example, PEDOT and PSS can be used as the electron hole transfer material. Furthermore, the hole injection layer 70 is not indispensable. In the above-described way, a layered body 400 including at least the anode (picture electrode) 23, the hole injection layer 70 and the organic bank layer 221 formed on the base body 100 is obtained.

(5) Next, the light emitting functional part 60 is formed on the hole injection layer 70 as shown in FIG. 4a. The manufacturing process of the light emitting functional part 60 is the same as that of the hole injection layer 70. For example, the material is discharged to a predetermined position of the hole injection layer 70 by the droplet discharging method. Then, a drying process is performed. In this way, the light emitting functional part 60 can be formed in the opening 221 a that is formed in the organic bank layer 221.

As the material for forming the light emitting functional part 60, in addition to the above-mentioned materials, such organic substances 65 as polyvinyl carbazole, polyfluorene-based polymer derivatives, (poly)paraphenyleneVinylene derivatives, polyphenylene derivatives, polythiophene derivatives and triallylamine derivatives, such metal complex 80 as a three-coordinate iridium metal complex having 2,2'- bipyridine-4,4'-dicarboxylic acid as its ligand and such metallic compound particles 90 as zirconium oxide, titanium oxide and silicon carbide can be used.

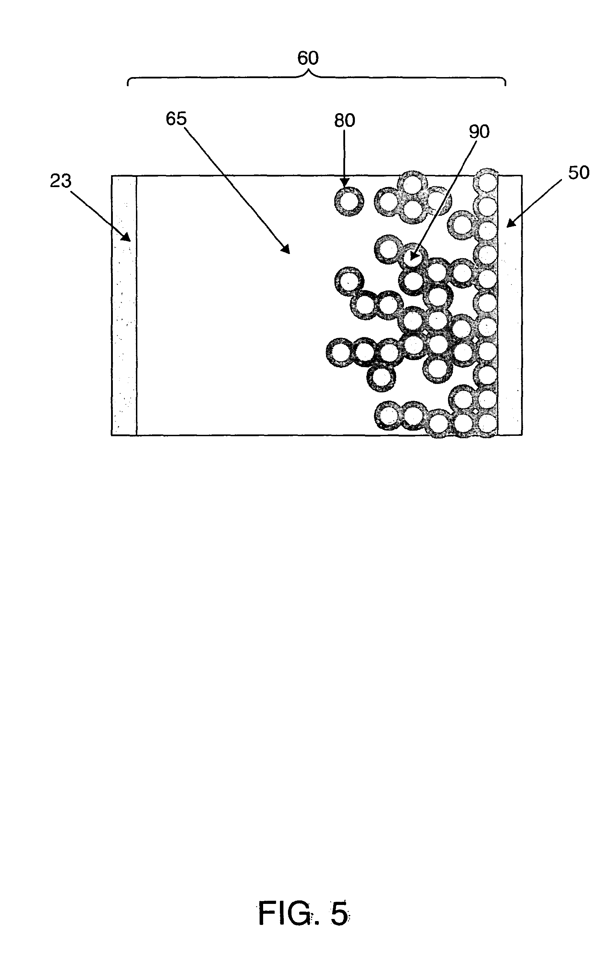

Embodiment of the light emitting functional part in this preferred embodiment will now be described. Firstly, synthesis of a complex is conducted. The above-mentioned 2,2'- bipyridine-4,4'-dicarboxylic acid (manufactured by TOKYO KASEI KOGYO CO., LTD.) is dissolved in a polar solvent such as water, alcohol (ethanol, isopropyl alcohol and the like) and dimethylformamide. At the same time, iridium chloride is separately dissolved in the same kinds of solvent. A concentration of the solution is adjusted such that a ratio of the ligand to the metal becomes 3:1. After the dissolution, they are mixed and agitated. After the sufficient reaction for 2-3 hours, sediment is taken out by using a filter. Then, it is cleaned with ethanol and dried. In the above-described way, an iridium complex is completed. Next, after the complex is dissolved in a halogen-based solvent (here, chloroform is adopted), this solution is accordingly added in other solution which includes the same kind of solvent and the zirconium oxide which is dispersed in the solvent in order to coordinate the complex with the zirconium oxide. After the adding, the solution is agitated for a day in order to make sufficient reaction. In this way, a zirconium oxide particle covered with the iridium complex is completed. Next, the polyvinyl carbazole and ADS254BE are dissolved in a nonpolar solvent such as xylene, toluene, cyclo hexyl benzene and dihydrobenzofuran. Then, the above-described zirconium oxide is added to the solution of the polyvinyl carbazole and ADS254BE. After the zirconium oxide is sufficiently dispersed, this solution is applied to the hole injection layer 70 or an anode 23 made of, for example, ITO by the liquid-phase process. Here, as described above, the liquid-phase process means the method of forming a thin film by applying the liquid with the spin-coat method, the dip-method or a droplet discharging method (an ink-jet method) and the like.
Alternatively, the above-described process may be performed in such way that the zirconium oxide is applied and fixed on the anode 23 made of, for example, ITO in an appropriate manner, and this is soaked in the above-described complex solution. In this case, the light-emitting functional part is completed by applying a polyvinyl carbazole dissolved in the above-mentioned nonpolar solvent after the soaking. A frame format of the light-emitting functional part is shown in FIG. 5.

In the above-described way, a layered body 500 including at least the anode (picture electrode) 23, the hole injection layer 70 and the light emitting functional part 60 formed on the base body 100 is obtained.

(6) Next, the electron injection layer, which is not shown in the figures, is formed according to need. To form the electron injection layer, an electron injection layer forming material is applied to the light emitting functional part 60 by the droplet discharging method.

(7) Next, the cathode 50 is formed on the light emitting functional part 60 as shown in FIG. 4b. In the forming process of the cathode 50, a film of a cathode material such as aluminum is formed by, for example, deposition, sputtering and the like.

Then, a sealing substrate 30 is formed in a sealing process. In this sealing process, a film 45 having a drying capability is adhered to the inside of the sealing substrate 30. Furthermore, the sealing substrate 30 and the substrate 20 are sealed with a sealant resin (not shown in the figures) in order to prevent water and oxygen from entering into the inside of the completed organic electroluminescence element. As the sealant resin, a heat-hardening resin and an ultraviolet curing resin are used. Moreover, it is preferred that this sealing process is performed in an inactive gas atmosphere such as nitrogen, argon and helium.

The organic electroluminescence device 1 obtained through the above-described processes finely emits light from the picture electrode 23 side when a voltage of, for example, smaller than 10 V, is applied between the both electrodes.

Though the cathode 50 is formed by a vapor process such as deposition, sputtering and the like in the above-described embodiment, the cathode may be formed by the liquid-phase process of using a solution or dispersion liquid containing a conductive material.

In other words, for example, the cathode 50 may be composed of a main cathode that is adjacent to the light emitting functional part 60 and a supplementary cathode that is put on the top of the main cathode. The main cathode and the supplementary cathode may be both formed of the conductive material. And the main cathode and the supplementary cathode are both formed by the liquid-phase process such as the droplet discharging method.

As the conductive material for forming the main cathode, a conductive polymer material that consists of a polymer compound including, for example, ethylene dioxythiophene, is used. More particularly, as the conductive polymer material, a dispersion liquid of 3,4-ethylene dioxythiophene/ polystyrene sulfonate can be used. Furthermore, as the conductive material for forming the main cathode 50, the metal particle may be used instead of the conductive polymer material, or the metal particle may be used together with the conductive polymer material. Especially, when the main cathode is made of the mixture material of the conductive polymer material and the metal particle, the main cathode can be calcined in relatively low temperature while the conductivity of the main cathode 50 is maintained. As the metal particle, gold, silver, aluminum and the like can be used. In addition to the metal particle such as gold and silver, carbon paste may also be used.

The supplementary cathode 223 is provided on the main cathode in order to enhance the conductivity of the whole cathode 50. The supplementary cathode 223 also protects the main cathode from oxygen and moisture by covering it and it can be made of the conductive metal particles. The metal particles are not especially limited as long as they are chemically stable conductive material, for example, metal and alloyed metal can be used to form them. To be more specific, aluminum, gold, silver and the like may be used.

As described above, when the cathode 50 is formed by the liquid-phase process, a vacuum environment is not necessary unlike the vapor process. Furthermore, the cathode 50 can be consecutively formed subsequently to the formation of the light emitting functional part 60. Therefore, the manufacturing process can be simplified and the productivity is raised. Furthermore, when the picture electrode (anode) is also formed by the liquid-phase process, the whole organic electroluminescence element including the anode, a functional layer (the hole injection layer, the light-emitting layer) and the cathode can be formed by the liquid-phase process. Therefore, the manufacturing process can be simplified and the productivity is raised.

Though the bottom-emission type is explained in the above-described embodiment, the present invention is not limited to this and can also be applied to the top-emission type and a type in which light is emitted from both top and bottom.

According to the manufacturing method of this embodiment, the functional organic layer, for example, all the hole injection layer, the organic light-emitting layer and the electron injection layer are formed by the liquid-phase process. Therefore, each layer can be more easily formed compared with a case where the each layer is formed by the vapor process.

### 5. Electronic equipment

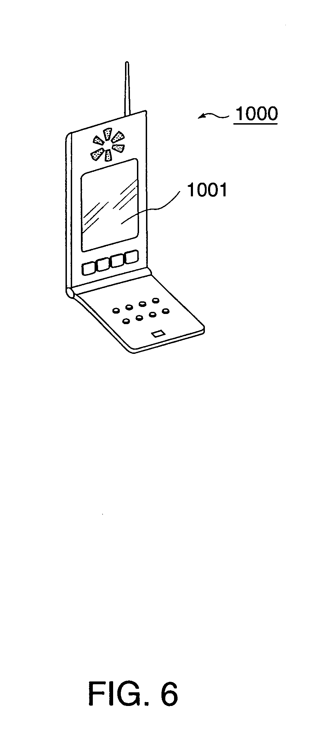

Next, embodiment of the electronic equipment according to the present invention will be described. The electronic equipment of the present invention has the above-described organic electroluminescence device 1 as a display part. To be more specific, a cellular phone shown in FIG. 6 can be taken as an example.

In FIG. 6, reference numeral 1000 designates a body of the cellular phone and reference numeral 1001 designates the display part which is the organic electroluminescence device I of the present embodiment. Because the cellular phone shown in FIG. 6 has the display part 1001 made of the organic electroluminescence device of the present embodiment, the cellular phone has a fine display properties.

In addition to the cellular phone, the electronic equipment of the preset embodiment includes a mobile information processor such as a word processor and a personal computer, a wristwatch type electronic equipment, a flat panel display (for example, television) and the like.

### [Industrial applicability]

The present invention is not limited to the above-described embodiments but may also be applied to a small-molecular type organic electroluminescence element.

Furthermore, though the display device having the organic electroluminescence element is described in the embodiment above, the present invention is not limited to this. The present invention may also be applied to a head of an ink-jet printer and the like.

### [List of Reference Numerals used in the drawings]

- 1:: ORGANIC ELECTROLUMINESCENCE DEVICE
- 11:: CIRCUIT MEMBER
- 20:: SUBSTRATE
- 23:: PICTURE ELECTRODE (ANODE)
- 50:: CATHODE
- 60:: LIGHT EMITTING FUNCTIONAL PART
- 65:: ORGANIC MATERIAL
- 70:: HOLE INJECTION LAYER
- 100:: BASE BODY
- 42:: SUBSTRATE
- 50:: ELECTRODE
- 80:: METAL COMPLEX
- 90:: METALLIC COMPOUND PARTICLE

## Claims

1. An organic electroluminescence device, comprising:
a light-emitting functional part made of an organic material, a metal complex and a particle of a metallic compound and formed between electrodes.

2. The organic electroluminescence device according to Claim 1, wherein the metallic compound and the metal complex have a covalent bonding.

3. The organic electroluminescence device according to any of Claims 1 and 2, wherein the organic material is an organic polymer material.

4. The organic electroluminescence device according to any of Claims 1 though 3, wherein a plurality kinds of organic materials are mixed in the organic material and each organic material has a phase separation interface.

5. The organic electroluminescence device according to any of Claims 1 though 4, wherein the metal complex is iridium metal complex.

6. The organic electroluminescence device according to any of Claims 1 though 5, wherein the metallic compound is metal oxide.

7. The organic electroluminescence device according to any of Claims 1 though 6, wherein the metallic compound is zirconium oxide.

8. A method of manufacturing the organic electroluminescence device as defined in any of claims 1 though 7, comprising:
forming the light-emitting functional part by using a liquid-phase process.

9. The method of manufacturing the organic electroluminescence device according to Claim 8, wherein a solution in which all the organic material, the metal complex and the particle of the metallic compound described in Claims 1 through 7 are mixed is used in the liquid-phase process.

10. An electronic equipment comprising the organic electroluminescence device according to any of Claims 1 though 7
